Europäisches Patentamt

European Patent Office

Office européen des brevets

(11) Veröffentlichungsnummer: 0 246 401
A1

## (12) EUROPÄISCHE PATENTANMELDUNG

(21) Anmeldenummer: 87102673.8

(22) Anmeldetag: 25.02.87

(51) Int. Cl.4: G01R 21/127

(30) Priorität: 20.05.86 CH 2059/86

(43) Veröffentlichungstag der Anmeldung:
25.11.87 Patentblatt 87/48

(84) Benannte Vertragsstaaten:
AT BE CH DE ES FR GB IT LI NL SE

(71) Anmelder: LGZ LANDIS & GYR ZUG AG

CH-6301 Zug(CH)

(72) Erfinder: Halder, Mathis
Burgmatt 28b
CH-6340 Baar(CH)
Erfinder: Oldigs, Robert
Loretohöhe 2
CH-6300 Zug(CH)

(54) Anordnung am Stromeingang eines Messgerätes, das der gleichzeitigen Messung zweier Messgrössen dient.

(57) Die Anordnung (14) besteht in einer Variante aus einem Stromwandler (4a; 4b; 9b), der eine Stromwandler-Primärwicklung (4a) und zwei Stromwandler-Sekundärwicklungen (4b, 9b) besitzt, denen je ein Pulsamplitudenmodulator (5, 10) zugeordnet und nachgeschaltet ist. Der Stromwandler (4a; 4b; 9b) bildet einen Eingangskreis (15) und die beiden Pulsamplitudenmodulatoren (5, 10) bilden einen Ausgangskreis 16 der Anordnung (14). Ein zweiter Pol einer jeden Stromwandler-Sekundärwicklung (4b bzw. 9b) ist jeweils mit einem zweiten Pol eines Amplituden-Eingangs des ihr nicht zugehörigen Pulsamplitudenmodulators (10 bzw. 5) verbunden. Die Schaltung ist einfach, raum-und preissparend.

Fig. 2

EP 0 246 401 A1

## Anordnung am Stromeingang eines Messgerätes, das der gleichzeitigen Messung zweier Messgrössen dient

Die Erfindung bezieht sich auf eine Anordnung am Stromeingang eines Messgerätes, das der gleichzeitigen Messung zweier Messgrössen dient, gemäss dem Oberbegriff des Anspruch 1 oder des Anspruchs 2.

Ein Messgerät der genannten Art dient z.B. der Messung zweier unterschiedlicher Arten von Energien oder Leistungen, wie z.B. Wirkenergie, Blindenergie, Scheinenergie, Wirkleistung, Blindleistung oder Scheinleistung, wobei alle möglichen Kombinationen denkbar und verwendbar sind. Das Messgerät ist z.B. ein mittels eines Pulsbreiten-Pulsamplituden-Modulators ("Mark space amplitude modulator") aufgebauter Elektrizitätszähler, der z.B. gleichzeitig Wirk-und Blindenergie misst. Die Blindenergie muss dabei nicht unbedingt direkt, sondern kann auch indirekt gemessen werden, wie z.B. im sogenannten Q-Elektrizitätszähler in den USA, wo ein sogenannter Q-Wert gemessen und mathematisch mit der gemessenen Wirkenergie verknüpft wird zur Bildung des Blindenergiewertes. In diesem Fall ist die zweite Messgrösse der Q-Wert.

Eine Anordnung der eingangs genannten Art ist im Handel erhältlich und zumindestens andeutungsweise in der Zeitschrift "Landis & Gyr - Mitteilungen" 32. Jahrgang (1985), 1, Tarifgeräte TARIGYR 400, Seiten 4 bis 8 beschrieben.

Der Erfindung liegt die Aufgabe zugrunde, eine Anordnung der eingangs genannten Art zu realisieren, die einfach, raumsparend und preissparend ist, ohne dabei die Dynamik des Messgerätes zu verschlechtern.

Die genannte Aufgabe wird erfindungsgemäss durch die im Kennzeichen des Anspruchs 1 oder des Anspruchs 2 angegebenen Merkmale gelöst.

Ausführungsbeispiele der Erfindung sind in der Zeichnung dargestellt und werden im folgenden näher beschrieben.

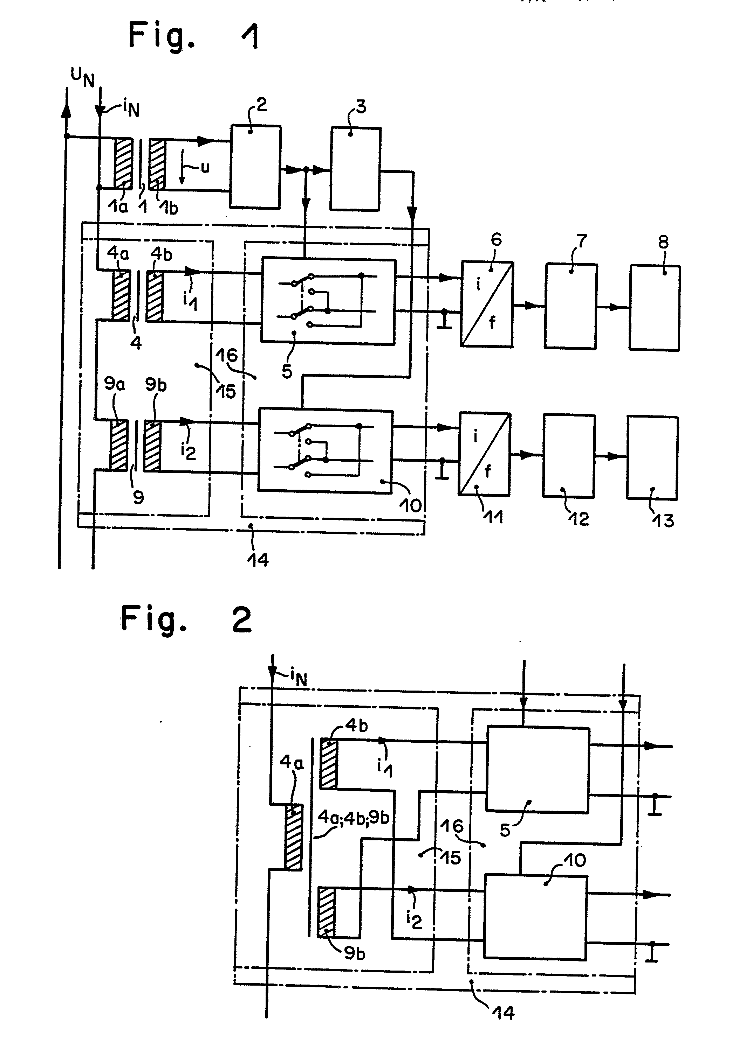

Es zeigen: Fig. 1 ein Schaltbild eines bekannten Messgerätes,
Fig. 2 ein Schaltbild einer ersten Variante einer beanspruchten Anordnung,
Fig. 3 ein Schaltbild einer zweiten Variante der beanspruchten Anordnung und
Fig. 4 ein Schaltbild einer dritten Variante der beanspruchten Anordnung.

Gleiche Bezugszahlen bezeichnen in allen Figuren der Zeichnung gleiche Teile.

In den Ausführungsbeispielen sind nur Einphasen-Schaltungen beschrieben. Es ist jedoch selbstverständlich, dass die beschriebenen Schaltungen ebenfalls in Dreiphasen-Anordnungen verwendet werden können.

Beim Aufbau eines kombinierten Messgerätes, das der Messung zweier Arten Energie bzw. Leistung dient, ist es naheliegend und bekannt, zwei getrennte Messgeräte der betreffenden Art zu nehmen und diese in einem einzigen Gehäuse unterzubringen. Ein Schaltbild eines derartigen kombinierten Messgerätes ist in der Fig. 1 dargestellt, wobei ein Spannungs-Messkreis 1; 2; 3 einfachheitshalber nicht zweimal, sondern nur einmal gezeichnet ist. Das in der Fig. 1 dargestellte Messgerät besteht mindestens aus einem Spannungswandler 1, einem Pulsbreitenmodulator 2, einem Verzögerungsglied 3, einem ersten Stromwandler 4, einem ersten Pulsamplitudenmodulator 5, einem ersten Strom/Frequenz-Wandler 6, einem ersten Zähler 7, einer ersten Anzeige 8, einem zweiten Stromwandler 9, einem zweiten Pulsamplitudenmodulator 10, einem zweiten Strom/Frequenz-Wandler 11, einem zweiten Zähler 12 und einer zweiten Anzeige 13. Eine Primärwicklung 1a des Spannungswandlers 1 ist zweipolig mit einer Netzwechselspannung $u_N$ und seine Sekundärwicklung 1b zweipolig mit dem Eingang des Pulsbreitenmodulators 2 verbunden. Der Spannungswandler 1, der Pulsbreitenmodulator 2 und das Verzögerungsglied 3 sind in der angegebenen Reihenfolge im Kaskade geschaltet und bilden zusammen den für beide Messgeräte gemeinsamen Spannungs-Messkreis 1; 2; 3. Der Ausgang des Pulsbreitenmodulators 2 ist ausserdem mit einem Steuereingang des ersten Pulsamplitudenmodulators 5 und der Ausgang des Verzögerungsgliedes 3 mit einem Steuereingang des zweiten Pulsamplitudenmodulators 10 verbunden. Im Pulsbreitenmodulator 2 werden binäre rechteckförmige Impulse erzeugt, deren Dauer durch die sinusförmige Netzwechselspannung $u_N$ bzw. durch eine ihr proportionale Ausgangsspannung u des Spannungswandlers 1 zeitlich moduliert ist. Die pulsbreitenmodulierten binären Ausgansimpulse des Pulsbreitenmodulators 2 werden im Verzögerungsglied 3 zeitlich verzögert, was einer Phasenverschiebung der Spannung u entspricht. Der Spannungs-Messkreis 1; 2; 3 kann auch anders aufgebaut sein, z.B. kann die Phasenverschiebung der Spannung u auch vor dem Pulsbreitenmodulator 2 erfolgen. In diesem Fall sind allerdings zwei Pulsbreitenmodulatoren, einer für die phasenverschobene und einer für die nichtphasenverschobene Spannung erforderlich. In der Fig. 1 der FR-OS 2541463 ist eine weitere Aufbaumöglichkeit des Spannungs-Messkreises 1; 2; 3 beschrieben. bei der ein Regelkreis zur Einstellung der Phasenverschiebung verwendet wird.

Stromwandler-Primärwicklungen 4a und 9a der beiden Stromwandler 4 und 9 sind elektrisch in Reihe geschaltet und werden von einem gleichen Netzwechselstrom $i_N$ durchflossen. Eine Stromwandler-Sekundärwicklung 4b des ersten Stromwandlers 4 ist zweipolig mit dem Amplitudeneingang des ersten Pulsamplitudenmodulators 5 und eine Stromwandler-Sekundärwicklung 9b des zweiten Stromwandlers 9 zweipolig mit dem Amplitudeneingang des zweiten Pulsamplitudenmodulators 10 verbunden. Der erste Stromwandler 4, der erste Pulsamplitudenmodulator 5, der erste Strom/Frequenz-Wandler 6, der erste Zähler 7 und die erste Anzeige 8 sind in der angegebenen Reihenfolge in Kaskade geschaltet und bilden zusammen ein erstes Messgerät 4; 5; 6; 7; 8, dass z.B. der Messung einer Wirkenergie oder Wirkleistung dient. Daher wird auch der Steuereingang des ersten Pulsamplitudenmodulators 5 direkt vom Ausgang des Pulsbreitenmodulators 2 mit unverzögerten binären pulsbreitenmodulierten Impulsen angesteuert. Der zweite Stromwandler 9, der zweite Pulsamplitudenmodulator 10, der zweite Strom/Frequenz-Wandler 11, der zweite Zähler 12 und die zweite Anzeige 13 sind ebenfalls in der angegebenen Reihenfolge in Kaskade geschaltet und bilden zusammen ein zweites Messgerät 9; 10; 11; 12; 13, das z.B. der Messung einer Blindenergie oder Blindleistung dient. In diesem Fall muss die durch das Verzögerungsglied 3 verursachte Verzögerungszeit einem Phasenwinkel von 90° der Spannung u entsprechen und der Steuereingang des zweiten Pulsamplitudenmodulators 10 muss wie dargestellt vom Ausgang des Verzögerungsgliedes angesteuert werden.

Die Ausgangsimpulse der beiden Pulsamplitudenmodulatoren 5 und 10 sind jeweils mit dem Sekundärstrom $i_1$ bzw. $i_2$ des Stromwandlers 4 bzw. 9 amplitudenmoduliert, wobei diese Sekundärströme jeweils proportional dem Netzwechselstrom $i_N$ sind. Die beiden Pulsamplitudenmodulatoren 5 und 10 dienen jeweils als Multiplizierschaltung, da die Flächen ihrer Ausgangsimpulse jeweils proportional dem Produkt $i_1 \cdot u$ bzw. $i_2 \cdot u \underline{|90°}$ und damit proportional der Wirkleistung bzw. der Blindleistung sind, wobei $u \underline{|90°}$ die um 90° phasenverschobene Spannung u darstellt.

Die beiden Pulsamplitudenmodulatoren 5 und 10 bestehen aus je einem zweipoligen Umschalter, der jeweils als Polaritätsumpoler beschaltet ist, d.h. am Ausgang ist ein Oeffnungskontakt des einen einpoligen Umschalters mit dem Schlisskontakt des andern einpoligen Umschalters verbunden und umgekehrt. Die Umschalter sind alle z.B. steuerbare Halbleiterschalter.

Die Sekundärströme $i_1$ und $i_2$ speisen somit über den jeweiligen ihnen zugehörigen Umschalter zweipolig den Eingang des Strom/Frequenz-Wandlers 6 bzw. 11, wobei ein Pol dieses Eingangs jeweils an Masse liegt, und werden dort durch Integration in eine Frequenz $f_1$ bzw. $f_2$ umgewandelt, die proportional der Wirk-bzw. der Blindleistung ist. Der Zähler 7 bzw. 12, der jeweils z.B. ein Binärzähler ist, zählt die binären Ausgangsimpulse des Strom/Frequenz-Wandlers 6 bzw. 11 über eine vorgegebene Zeit und der Zählwert wird anschliessend mit der Anzeige 8 bzw. 13 angezeigt. Der Anzeigewert der ersten Anzeige 8 entspricht dabei je nach Zählzeit der gemessenen Wirkenergie bzw. Wirkleistung und derjenige der zweiten Anzeige 13 der Blindenergie bzw. Blindleistung.

Die beiden Stromwandler 4 und 9 und die beiden Pulsamplitudenmodulatoren 5 und 10 bilden zusammen eine Anordnung 14 am Stromeingang des in der Fig. 1 dargestellten Messgerätes, wobei die beiden Stromwandler 4 und 9 einen Eingangskreis 15 und die beiden Pulsamplitudenmodulatoren 5 und 10 einen Ausgangskreis 16 bilden. Die Verwendung zweier getrennter Stromwandler 4 und 9 ist platzraubend und preistreibend. Um dies zu vermeiden, kann eine der drei nachfolgend beschriebenen Varianten verwendet werden.

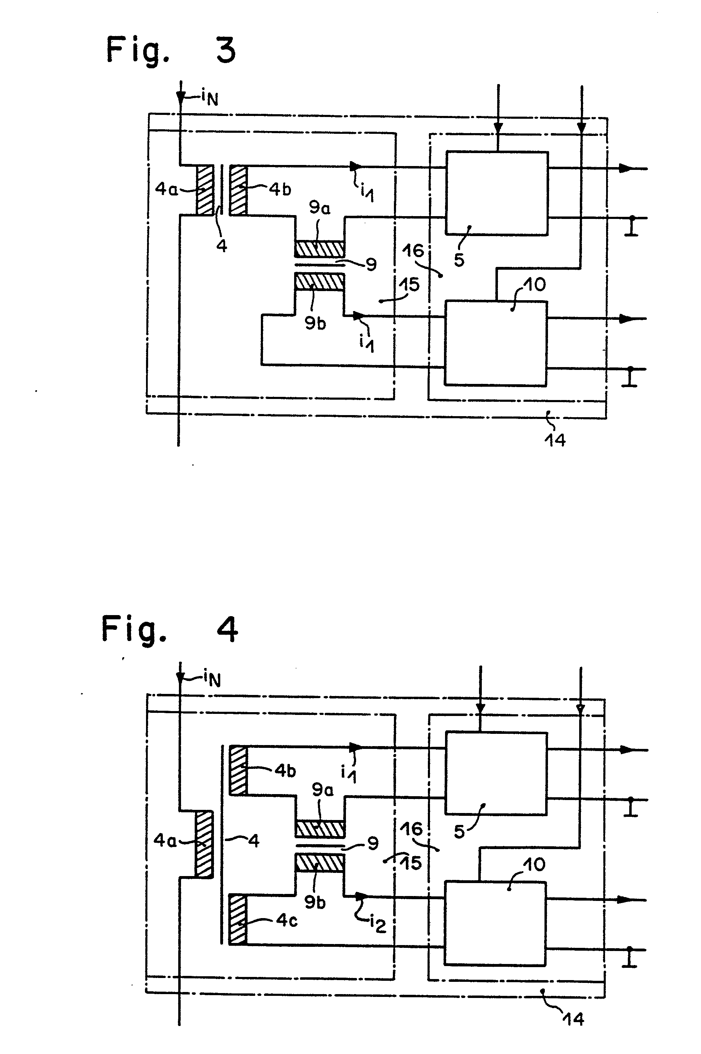

Die in der Fig. 2 dargestellte erste Variante einer Anordnung 14 besteht genau wie die in der Fig. 1 dargestellte Anordnung 14 aus einem Eingangskreis 15 und einem Ausgangskreis 16, wobei der letztere genau so aufgebaut und verdrahtet ist wie derjenige, der in der Fig. 1 dargestellt ist. Der Eingangskreis 15 besteht seinerseits diesmal aus einem einzigen Stromwandler 4a; 4b; 9b mit einer Stromwandler-Primärwicklung 4a und zwei gleich grossen oder zumindestens zwei annähernd gleich grossen Stromwandler-Sekundärwicklungen 4b und 9b. Jeder der beiden Stromwandler-Sekundärwicklungen 4b und 9b ist einer der Pulsamplitudenmodulatoren 5 bzw. 10 des Ausganskreises 16 zugeordnet und nachgeschaltet. Ein erster Pol einer jeden Stromwandler-Sekundärwicklung 4b bzw. 9b ist jeweils mit einem ersten Pol des Amplituden-Eingangs des zugehörigen Pulsamplitudenmodulators 5 bzw. 10 verbunden. Der zweite Pol einer jeden Stromwandler-Sekundärwicklung 4b bzw. 9b ist jeweils mit einem zweiten Pol des Amplituden-Eingangs des ihr nicht zugehörigen andern Pulsamplitudenmodulators 10 bzw. 5 verbunden. Die Stromwandler-Primärwicklung 4a ersetzt hier die Reihenschaltung der beiden Primärwicklungen 4a und 9a der Fig. 1 und wird vom Netzwechselstrom $i_N$ durchflossen. Es wird bei dieser Variante ein Stromwandler eingespart, ohne dabei auf die für die Dynamik des Messgerätes vorteilhafte Stromspeisung der Pulsamplitudenwandler 5 und 10 verzichten zu müssen. Durch die speziellen Anschlüsse der Stromwandler-Sekundärwicklungen 4b und 9b wird ausserdem vermieden, dass Wicklungstoleranzen dieser beiden Wicklungen 4b und 9b ungleiche Eingangsströme in den Strom/Frequenz-Wandlern 6 und 11 verursachen. Im Mittelwert über die Zeit betrachtet sind diese beiden Eingangsströme nämlich trotz allfälligen Wicklungsunterschieden gleich gross. Besitzen die beiden Umschalter, die die beiden Pulsamplitudenmodulatoren 5 und 10 bilden, die in der Fig. 1 dargestellte Position, dann fliesst im Eingangswiderstand des ersten Strom/Frequenz-Wandlers 6 ausschliesslich der Sekundärstrom $i_1$ und im Einganskreis des zweiten Strom/Frequenz-Wandlers 11 ausschliesslich der Sekundärstrom $i_2$, da die Masse jeweils als Kurzschluss für den andern Sekundärstrom $i_2$ bzw. $i_1$ wirksam ist. Aendert jetzt der Umschalter des Pulsamplitudenmodulators 5 unter Einfluss des Ausgangssignals des Pulsbreitenmodulators 2 (siehe Fig. 1) seine Position, so ändert sich beim Einganswiderstand des zweiten Strom/Frequenz-Wandlers 11 elektrisch nichts, da er weiterhin ausschliesslich vom Sekundärstrom $i_2$ durchflossen wird, wenn der Umschalter des zweiten Pulsamplitudenmodulators 10 seine Position beibehält. Jedoch im Eingangswiderstand des ersten Strom/Frequenz-Wandlers 6 fliesst diesmal der Sekundärstrom $- i_2$ statt $i_1$. Der erste Strom/Frequenz-Wandler 6 bildet mit Hilfe eines in ihm enthaltenen, nicht darstellten Integrators somit während zweier aufeinanderfolgenden Halbwellen des Ausgangssignals des Pulsbreitenmodulators 2 einen Mittelwert $((i_1 \bullet T/2) - (-i_2 \bullet T/2)) /T = i_2)/2$ und damit am Ausgang des Strom/Frequenz-Wandlers 6 eine Frequenz, die proportional dem Netzwechselstrom $i_N$ ist, der seinerseits bekanntlich proportional $(i_1 + i_2)$ ist. Der Eingangsstrom des ersten Strom/Frequenz-Wandlers 6 ist somit unabhängig von Wirklungsunsymmetrien der beiden Sekundärwicklungen 4b und 9b des Stromwandlers 4a; 4b; 9b und im Mittelwert immer proportional dem Netzwechselstrom $i_N$. Aehnliche Ueberlegungen führen beim zweiten Strom/Frequenz-Wandler 11 zum gleichen Resultat.

Die in der Fig. 3 dargestellte zweite Variante ist ähnlich aufgebaut wie die erste Variante mit dem Unterschied, dass der Eingangskreis 15 neben einem ersten Stromwandler 4 noch einen zweiten Stromwandler 9 besitzt, dessen Uebersetzungsverhältnis annähernd eins ist. Beide Stromwandler 4 und 9 besitzen je eine Primärwicklung 4a bzw. 9a und je eine einzige Sekundärwirklung 4b bzw. 9b. Jede Stromwander-Sekundärwicklung 4b bzw. 9b ist zweipolig mit dem Amplituden-Eingang des ihr zugehörigen Pulsamplitudenmodulators 5 bzw. 10 verbunden. Der zweite Pol der Stromwandler-Sekundärwicklung 4b des ersten Stromwandlers 4 ist über die Primärwicklung 9a des zweiten Stromwandlers 9 mit dem zweiten Pol des Amplituden-Eingangs des ihr zugehörigen Pulsamplitudenmodulators 5 verbunden. Der Sekundärstrom $i_1$ des ersten Stromwandlers 4 speist einerseits über den ersten Pulsamplitudenmodulator 5 den ersten Strom/Frequenz-Wandler 6 und anderseits über den zweiten Stromwandler 9 und den zweiten Pulsamplitudenmodulator 10 den zweiten Strom/Wandler 11, wobei dessen so erzeugter Eingangsstrom zumindestens annähernd gleich dem Sekundärstrom $i_1$ des ersten Stromwandlers 4 ist, da das Uebersetzungsverhältnis des zweiten Stromwandlers 9, wie bereits erwähnt, gleich eins ist. Der zweite Stromwandler 9 ist ein Hilfswandler, der keine Primär/Sekundär-Stossspannungen aushalten muss und daher in den Abmessungen bedeutend kleiner sein kann als der erste Wandler 4.

Die in der Fig. 4 dargestellte dritte Variante ähnelt der zweiten Variante mit dem Unterschied, dass der erste Stromwandler 4 eine weitere Stromwandler-Sekundärwicklung 4c besitzt, die annähernd gleich gross wie die andere Stromwandler-Sekundärwicklung 4b des ersten Stromwandlers 4 ist, und dass ein Pol der Stromwandler-Sekungärwicklung 9b des zweiten Stromwandlers 9 über diese weitere Stromwandler-Sekundärwicklung 4c des ersten Stromwandlers 4 mit dem ihm zugehörigen Pol des Amplituden-Eingangs des zugehörigen Pulsamplitudenmodulators 10 verbunden ist. In den Eingangswiderständen der beiden Strom/Frequenz-Wandler 6 und 11 fliesst je ein Sekundärstrom $i_1$ bzw. $i_2$ des ersten Stromwandlers 4, wobei beide Ströme ohne das Vorhandensein des zweiten Stromwandlers 9 nur annähernd gleich gross sind. Das Uebertragungsverhältnis des zweiten Stromwandlers 9 ist wieder annähernd eins, jedoch die Wicklungsrichtungen der beiden Stromwandler-Wicklungen 9a und 9b sind entgegengesetzt. Wenn die beiden Sekundärströme $i_1$ und $i_2$ genau gleich gross sind, dann induzieren sie beide in jede der beiden Stromwandler Wicklungen 9a und 9b je eine gleich grosse Spannung entgegengesetzter Polorität, die sich beide in jede der beiden Stromwandler-Wicklungen 9a und 9b gegenseitig aufheben. Sind die beiden Sekundärströme $i_1$ und $i_2$ dagegen leicht unterschiedlich, dann sind auch die beiden in jede der beiden Stromwandler-Wicklungen 9a und 9b induzierten Spannungen leicht unterschiedlich und ihre Differenz ist somit unterschiedlich von null. Diese Spannungsdifferenz erzeugt jeweils in dem ihr zugehörigen Stromkreis 9a; 4b bzw. 9b; 4c einen zusätzlichen Strom, der sich in einem der beiden Stromkreise 9a; 4b und 9b; 4c zum zugehörigen Sekundärstrom $i_1$ bzw. $i_2$ addiert und der sich im andern Stromkreis vom zugehörigen

Sekundärstrom $i_2$ bzw. $i_1$ subtrahiert, so dass der gesamte, in jedem der beiden Stromkreise 9a; 4b und 9b; 4c fliessende Strom für beide Stromkreise 9a; 4b und 9b; 4c wieder ·gleich gross ist. Der zweite Stromwandler 9 arbeitet somit als eine Art Regler, der die Ströme in beiden Stromkreisen 9a; 4b und 9b; 4c gleich gross hält. Da die Sekundärwicklungen 4b und 4c des ersten Stromwnadlers 4 in dieser dritten Variante nur halb so viele Windungen besitzen müssen wie die Sekundärwicklung 4b in der zweiten Variante, unterscheiden sich die ersten Stromwandler 4 dieser beiden Varianten aufbaumässig nur dadurch, dass in der dritten Variante der erste Stromwandler 4 zwei Ausgangsklemmen mehr besitzen muss als in der zweiten Variante. Ansonsten besitzt die dritten Variante gleiche Vorteile wie die erste Variante mit dem zusätzlichen Vorteil, dass beide Pulsamplitudenmodulatoren 5 und 10 galvanisch voneinander· getrennt sind.

**Ansprüche**

1. Anordnung (14) am Stromeingang eines Messgerätes, das der gleichzeitigen Messung zweier Messgrössen dient, mit mindestens einer Stromwandler-Primärwicklung (4a) und mindestens zwei Stromwandler-Sekundärwicklungen (4b, 9b), wobei jeder Stromwandler-Sekundärwicklung (4b, 9b) ein Pulsamplitudenmodulator (5, 10) zugeordnet und nachgeschaltet ist und wobei ein erster Pol einer jeden Stromwandler-Sekundärwicklung (4b bzw. 9b) jeweils mit einem ersten Pol eines Amplituden-Eingangs des zugehörigen Pulsamplitudenmodulators (5 bzw. 10) verbunden ist, dadurch gekennzeichnet, dass nur ein Stromwandler (4a; 4b; 9b) vorhanden ist mit zwei annähernd gleich grossen Stromwandler-Sekundärwicklungen (4b, 9b) und dass ein zweiter Pol einer jeden Stromwandler-Sekundärwicklung (4b bzw. 9b) jeweils mit einem zweiten Pol des Amplituden-Eingangs des ihr nicht zugehörigen Pulsamplitudenmodulators (10 bzw. 5) verbunden ist.

2. Anordnung (14) nach dem Oberbegriff des Anspruchs 1 mit zwei Stromwandlern (4, 9), die je eine Stromwandler-Sekundärwicklung (4b bzw. 9b) besitzen, wobei jede Stromwandler-Sekundärwicklung (4b bzw. 9b) zweipolig mit dem Amplituden-Eingang des ihr zugehörigen Pulsamplitudenmodulators (5 bzw. 10) verbunden ist, dadurch gekennzeichnet, dass ein zweiter Pol der Stromwandler-Sekundärwicklung (4b) eines ersten Stromwandlers (4) über eine Primärwicklung (9a) des zweiten Stromwandlers (9) mit einem zweiten Pol des Amplituden-Eingangs des ihr zugehörigen Pulsamplitudenmodulators (5) verbunden ist und dass das Uebersetzungsverhältnis des zweiten Stromwandlers (9) annähernd eins ist.

3. Anordnung (14) nach Anspruch 2, dadurch gekennzeichnet, dass der erste Stromwandler (4) eine weitere Stromwandler-Sekundärwicklung (4c) besitzt, die annähernd gleich gross wie die andere Stromwandler-Sekundärwicklung (4b) des ersten Stromwandlers (4) ist, dass ein Pol der Stromwandler-Sekundärwicklung (9b) des zweiten Stromwandlers (9) über diese weitere Stromwandler-Sekundärwicklung (4c) des ersten Stromwandlers (4) mit dem ihm zugehörigen Pol des Amplituden-Eingangs des zugehörigen Pulsamplitudenmodulators (10) verbunden ist und dass die Wicklungsrichtungen der beiden Stromwandler-Wicklungen (9a, 9b) des zweiten Stromwandlers (9) entgegengesetzt sind.

## Fig. 1

## Fig. 2

# Fig. 3

# Fig. 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | LANDIS & GYR-MITTEILUNGEN, Band 21, Nr. 4, 1974, Seiten 48-54, Zug, CH; H. LAUMANN et al.: "Präzisionszähler Klasse 0,5 mit statischem Messwerk" * Seite 52, Spalte 3, Zeile 36 - Seite 53, Spalte 1, Zeile 9; Figur 9 * | 1,2 | G 01 R 21/127 |
| A | DE-C- 942 881 (A. LEONARD) * Figur * | 1 | |
| A | US-A-3 500 200 (P. WOODHEAD) * Zusammenfassung, Spalte 1, Zeile 63 - Spalte 2, Zeile 3; Spalte 2, Zeilen 23-35; Figur 1 * | 1 | |
| A | DE-A-2 456 942 (DEUTSCHE ZAHLER-GESELLSCHAFT NACHF. A. STEPPER & CO.) | | **RECHERCHIERTE SACHGEBIETE (Int. Cl.4)**<br><br>G 01 R |

Der vorliegende Recherchenbericht wurde für alle Patentansprüche erstellt.

| Recherchenort | Abschlußdatum der Recherche | Prüfer |
|---|---|---|
| DEN HAAG | 28-08-1987 | PENZKOFER, B. |